Europäisches Patentamt

(19) European Patent Office

Office européen des brevets

(11) Publication number: 0 176 329
A2

(12) **EUROPEAN PATENT APPLICATION**

(21) Application number: 85306729.6

(22) Date of filing: 23.09.85

(51) Int. Cl.⁴: **H 01 S 3/08**
H 01 S 3/10, G 02 B 26/10

(30) Priority: 24.09.84 US 653633

(43) Date of publication of application:
02.04.86 Bulletin 86/14

(84) Designated Contracting States:
DE FR GB

(71) Applicant: XEROX CORPORATION
Xerox Square - 020
Rochester New York 14644(US)

(72) Inventor: Ritter, Joachim Albert
753 S. Huckleberry Way
Webster New York 14580(US)

(72) Inventor: Banton, Martin Edward
22 Timber Lane
Fairport New York 14450(US)

(72) Inventor: Daniele, Joseph John
321 Thornell Road
Pittsford New York 14534(US)

(74) Representative: Weatherald, Keith Baynes et al,
European Patent Attorney Rank Xerox Limited Patent
Department 338 Euston Road
London NW1 3BH(GB)

(54) Laser diodes.

(57) A raster output scanner with laser diode and a holographic beam scanning system, an anti-reflective coating (36) on the diode internal cavity facet (34) such that the diode internal cavity functions as a gain medium only, an exterior cavity (39) with lens for collimating radiation emitted by the diode into a bundle of parallel beams, a holographic grating for dispersing the beams by wavelengths, and means (50, 65, 70) for reflecting the beams at only one wavelength back on itself through the grating and lens to the diode front facet to force the diode to operate in a single longitudinal mode at the one wavelength.

A second embodiment provides a unitary structure housing the laser diode and the external cavity forming elements with the beam-splitting mirror in the form of a prism to guide the single mode beam of the diode along the scanner optical path. A third embodiment replaces the beam-splitting mirror with a totally-reflecting mirror, and a fourth embodiment replaces both the grating and beam-splitting mirror by a reflective grating.

FIG. 2

The invention relates to raster output scanners with laser diode and holographic beam scanning system, and more particularly, to a modified laser diode designed to prevent diode mode-hopping, for use in raster output scanners.

As the technology of raster output scanners, often referred to as ROS's, evolves, one major improvement of interest involves replacement of the scanning polygon and the relatively complex cylindrical correction optics normally associated therewith with a holographic scanning system. In that type of scanning system, a holographic disc having a succession of grating facets about the periphery thereof is used in place of a polygon to raster scan the imaging beam across a recording member. A further improvement commensurate with this would replace the relatively-bulky gas laser and its attendant modulator with a relatively-small internally-modulated laser diode.

However, combining a laser diode with a holographic scanning system presents at least one major problem, i.e. the tendency of laser diodes to mode hop because of the diode's inherent frequency instability. This tendency of laser diodes is rooted in the very broad gain curve of a laser diode and its tendency to shift frequencies with changes in temperature. As a result, laser diodes, even those laser diodes normally operating as single longitudinal mode lasers, shift from one longitudinal mode to another as temperature, equivalent duty cycle or power level change.

While a number of techniques have been employed in attempts to stabilize laser diodes and limit their operation to a single mode and prevent mode hopping, few if any have been commercially successful or practical. One technique for example uses either a etalon, bi-refringent filter, or blazed grating to prevent mode hopping. However, systems of these types are quite expensive and hence are not attractive, especially where scanner cost is of paramount importance. Another laser diode stabilizing technique employing an external cavity uses simple end mirrors. However, this technique, to be successful, requires extreme mechanical stability which is difficult if not impossible to achieve in raster scanners which have a number of moving parts including a relatively large recording member. Further, the latter technique does not permit wavelength tuning, a property that is particularly advantageous when using a holographic scanning system.

The invention seeks to solve the aforementioned problems, and provides a relatively-inexpensive and practical single mode laser diode which is as claimed in the appended claims.

The invention further relates to a method of preventing mode hopping in a laser diode, as claimed below.

The present invention will now be described by way of example with reference to the accompanying drawings, in which:

Figure 1 is a schematic view depicting a known raster output scanning system having means to nullify fast scan effects of laser diode mode hopping at zero scan angle only, with cross scan effects nullified at all scan angles;

Figure 2 is a schematic view depicting the laser diode of the present invention in which the diode internal lasing cavity is used only as a gain medium and an external lasing cavity is provided incorporating means to limit diode operation to a single longitudinal mode;

Figure 3 is a view, partially in section, showing the laser diode of the present invention incorporated into a unitary structure for interaction with a holographic scanning system;

Figure 4 is a schematic view of an alternative embodiment of the invention, in which a totally-reflective mirror is used in place of the beam-splitting mirror of Figure 2, and

Figure 5 is a schematic view depicting a second alternative embodiment in which a reflective holographic grating is used in place of the beam-splitting mirror and transmissive grating of Figure 2.

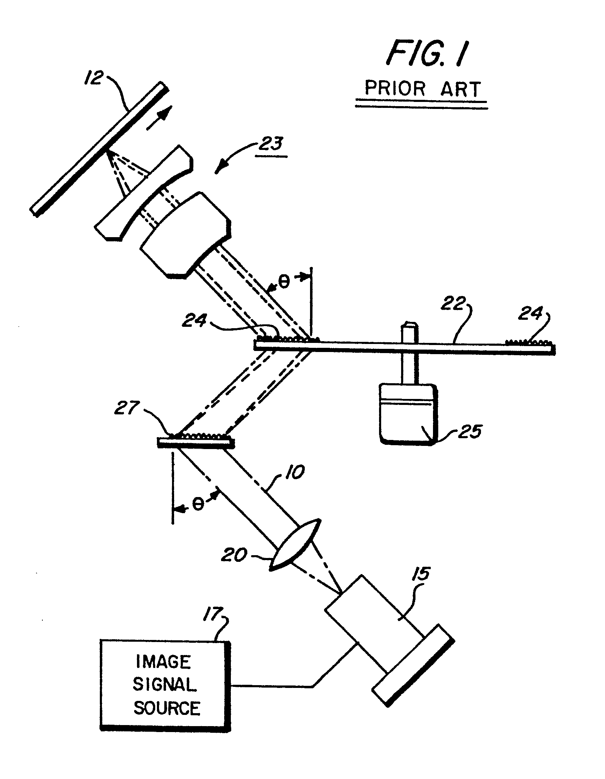

Referring to the known arrangement shown in Figure 1, there is shown a raster output scanner (ROS) in which a high intensity laser beam 10, modulated in accordance with an image signal input, is scanned across a record member 12 to expose member 12 selectively. The image produced on the record member 12 is thereafter developed to provide a visible image.

Record member 12 may comprise any suitable medium, such as the photoreceptor of a xerographic type imaging system. In systems of that type, the photoreceptor is first uniformly charged and then exposed by beam 10 to form a latent electrostatic image thereon as represented by the image signal input. The latent electrostatic image is thereafter developed and the developed image transferred to a suitable copy substrate material such as paper. Following transfer, the image is fixed as by fusing to form a permanent image. As will be understood, record member 12 may be in any suitable form such as drum, web, belt, etc.

Beam 10 is generated by a suitable laser diode 15 which may for example comprise a Hitachi Model No. 7801E diode. An internal modulating circuit enables the beam output by diode 15 to be modulated by the image signal input. The image signals may be obtained from any suitable source 17 which may comprise a memory, an input scanner, communication channel, etc.

The modulated beam 10 output by diode 15 passes through a suitable collimating lens 20 and compensating grating 27 and impinges at an angle of substantially $45^\circ$ on the grating facets 24 of a rotating holographic disc 22. Disc 22 has a succession of facets 24 around the periphery thereof such that on rotation of disc 22 by motor 25, each facet 24 scans the beam 10 across record member 12 in the X direction. Concurrently, record member 12 is moved by a suitable drive means (not shown) in the Y direction (the direction shown by the solid line arrow in Figure 1). A suitable lens 23 is provided downstream of disc 22 for focusing beam 10 to a point on record member 12.

In the Figure 1 arrangement, frequency compensating grating 27 was initially used to permit a wide selection of laser diodes operating at different wavelengths. However, as will be understood, grating 27 also nullifies mode-hopping effects in the cross scan direction at all scan angles, and fast scan effects only at zero scan angle. Grating 27 is disposed in a plane parallel to the plane of rotation of holographic disc 22 with beam 10 incident on grating 27 at an angle $\theta$ of approximately $45^\circ$. As a result, the output beam is incident to both grating 27 and facets 24 of holographic disc 22, at an angle of approximately $45^\circ$. However, as indicated above, grating 27 provides wavelength compensation only at a zero scan angle. This results in mode-hopping induced jitter along the scan axis (i.e. the X axis), the magnitude of such errors being dependent on the operating parameters of the raster output scanner.

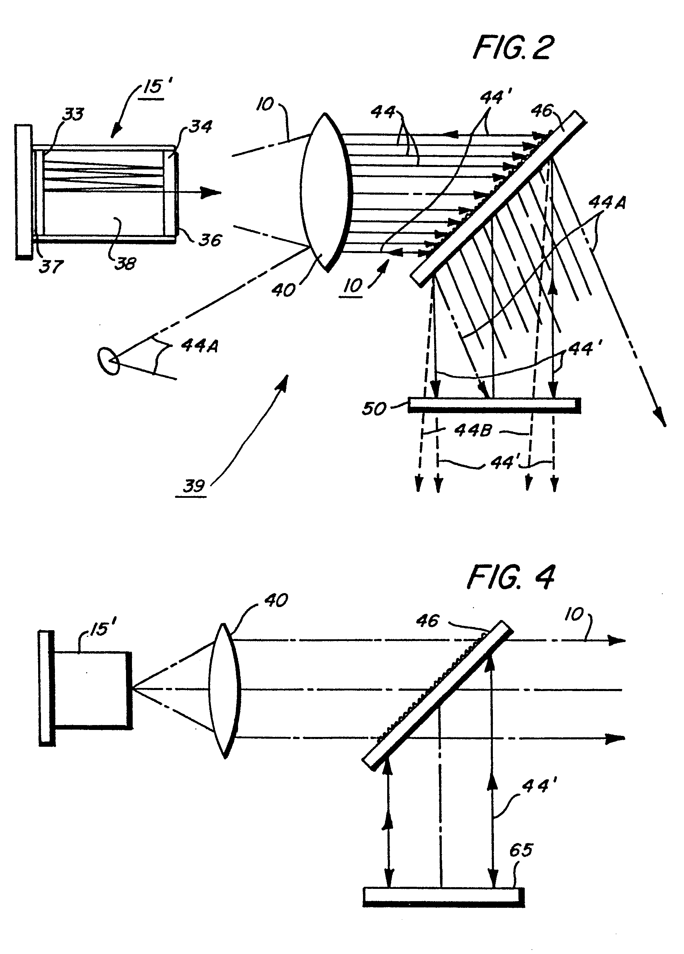

Referring particularly to Figure 2, a laser diode 15' is modified to change the diode from an internal cavity type to an external cavity type so that the diode internal cavity 38 is used as a gain medium only. This is accomplished by coating the reflective surface of the diode's internal cavity beam emitting facet 34 (front facet) with a suitable anti-reflective coating 36 such as silicon monoxide (SiO), which substantially increases the loss in the diode internal cavity 38 so that at normal operating currents, the gain is much less than the loss. As a result, the internal cavity threshold current is raised well above that at which lasing formally occurred in the internal cavity. However, the threshold current of the external cavity as described herein is well below this now-elevated internal cavity threshold. Hence the external cavity dominates the internal cavity at normal operating currents. The diode rear facet 33 may be coated with reflective coating 37 to reduce losses in the external cavity.

An external cavity, designated generally by the numeral 39, is formed using a suitable collimating objective lens 40 in the path of the beam 10 output by diode 15' to collimate the different wavelengths of light emitted from diode 15' (resulting from laser mode hopping) into a parallel bundle of light rays 44. A grating 46 disperses the light, in accordance with the wavelength of the individual light rays 44 that comprise the beam, on to a suitable beam-splitting mirror 50. Mirror 50 is arranged so that only one light ray 44' at a preselected wavelength is reflected by mirror 50 back onto itself and through grating 46 to collimating lens 40. Lens 40 focuses the reflected ray 44' onto front facet 34 of internal cavity 38 to force diode 15' to operate at a single mode at a preselected wavelength. Rays 44A and 44B, although reflected back through the optical system, are not focused back into the gain medium. As a result, operation of diode 15' is stabilized and mode-hopping is obviated.

External cavity 39 may be tuned to select the optimum operating mode and wavelength desired by pivoting grating 46, or mirror 50, or both grating 46 and mirror 50 together.

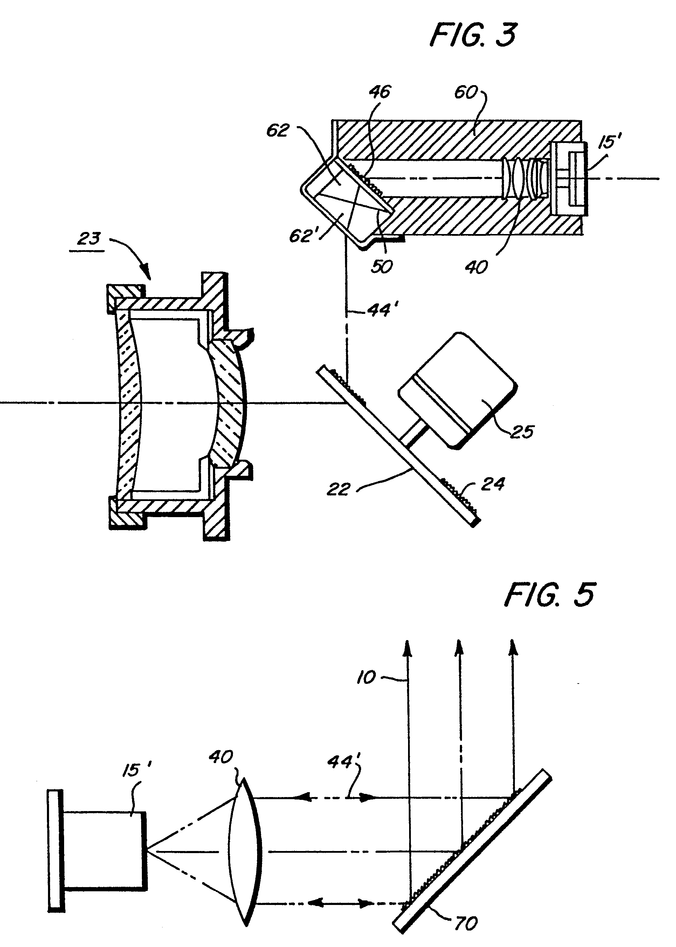

Referring to the embodiment shown in Figure 3, where like numerals refer to like parts, a housing 60 is provided for supporting laser diode 15' and collimating lens 40, grating 46, and beam-splitting mirror 50 as a unit in predetermined operative relation to one another. In this embodiment, beam-splitting mirror 50 is located between prisms 62, 62' to reflect the single mode output beam 44' along the system optical axis to facets 24 of holographic disc 22.

In the embodiment shown in Figure 4, where like numerals refer to like parts, beam-splitting mirror 50 is replaced by a totally-reflecting mirror 65. As a result, the output beam 10 is extracted from the zero order of grating 46. It will be understood that since grating 46 can never be made 100% efficient, some amount of zero order light will always exist. Since conventional gratings are approximately 70% to 80% efficient, some 20% to 30% of the energy is in the zero order beam and therefore available for output. Accordingly, substantially all of the laser energy is used either in feedback or output.

In the embodiment shown in Figure 5, where like numerals refer to like parts, beam-splitting mirror 50 is dispensed with and holographic grating 46 is replaced by a reflective grating 70 operating in the Littrow configuration to serve both as a frequency selective feedback and beam-splitting element. Grating 70 diffracts approximately 70% of the energy of the selected wavelength back into the diode cavity 38 in the first order of diffraction, leaving approximately 30% of the energy in the zero order for output beam 10. As a result, this embodiment provides high net feedback and very little energy waste.

CLAIMS:

1.      An external-cavity stabilized single mode laser diode having front and back reflective facets, (33, 34) comprising;

a)      a collimating objective lens (40) for collimating radiation emitted by the laser diode into a parallel bundle of different wavelength rays;

b)      a holographic plane transmissive grating (46) for dispersing the rays in accordance with their wavelengths; and

c)      means (50, 65, 70) for reflecting only the rays leaving the grating at a specified angle back along their path and through the grating and collimating lens to said diode, the lens focusing the back-reflected rays on the front facet, to the exclusion of any other rays, whereby the laser diode is forced to operate in a single longitudinal mode corresponding to the single wavelength of back-reflected rays.

2.      The diode according to claim 1, including an anti-reflective coating (36) on the front facet to reduce its reflectivity.

3.      The diode according to claim 1 or 2, including a reflective coating (37) on the back facet to increase its reflectivity.

4.      The diode according to any preceding claim, in which reflecting means comprises two prisms with a partially-reflective surface interposed therebetween.

5.      The diode according to any of claims 1-3, in which the reflecting means is totally reflective.

6.      The diode according to any of claims 1-3, in which the reflecting means comprises a reflective grating.

7.      The diode according to any preceding claim, including means for adjusting the angle of the reflecting means to select rays of a chosen wavelength.

8. A method of preventing mode-hopping in a laser diode to enhance use of the laser diode as the source of the image scan beam in a raster output scanner, comprising the steps of:

a) collimating the radiation emitted by the laser diode into parallel rays of different wavelengths;

b) dispersing said rays in accordance with their wavelengths; and

c) reflecting the rays at only one wavelength back along their paths and into the gain medium of the laser diode to force it to operate in a single mode corresponding to the said one wavelength.

9. The method according to claim 8, including the step of coating the lasing facet with an anti-reflective coating whereby the laser diode functions as a gain medium only to render the internal cavity of the laser diode inoperative.

0176329

FIG. 1

PRIOR ART

FIG. 2

FIG. 4

0176329

## FIG. 3

## FIG. 5